# EUROPEAN PATENT APPLICATION

(11) **EP 4 679 069 A1**
(43) Date of publication of application: **14.01.2026**
(21) Application number: 25179594.4
(22) Date of filing: 28.05.2025
(51) Int. Cl.: G01N 23/2251

(54) **INTELLIGENT STOPPING CRITERIA FOR ENERGY DISPERSIVE X-RAY ACQUISITION**

(30) Priority: 11.07.2024 US 202463669798 P
(71) Applicant: FEI Company, Hillsboro, OR 97124-5793 (US)
(72) Inventor: KHALIL, Mohamad, Eindhoven (NL); POTOCNÁK, Tomás, Eindhoven (NL); HLAVICKA, Ivo, Blansko (CZ)
(74) Representative: Boult Wade Tennant LLP

(57) **Abstract**

A method for constructing an optimal-setting prediction model, comprises: (I) setting one or more microscope operational parameters to respective initial values; (II) directing a charged particle beam onto a specimen of a first known sample type and imaging or analyzing the specimen using the most recently set microscope operational parameters while detecting emissions from the specimen; (III) repeatedly: (i) changing a value of at least one of the one or more operational parameters; (ii) directing the charged particle beam onto a different specimen of the first known sample type and imaging or analyzing the different specimen using the most recently set microscope operational parameters while detecting emissions from the different specimen; and (iii) recording the values of the microscope operational parameters and recording a value that is a measure of the detected emissions from the different specimen; and (IV) constructing and storing a mathematical relationship, pertaining to the first known sample type, between at least one variable that represents a microscope operational parameter and a variable that represents the detected emissions.

## Description

### TECHNICAL FIELD

The present application relates, in general, to charged particle beam microscopes, and charged particle beam microscopy and, more particularly, to charged particle beam microscopes having Energy Dispersive X-ray microanalysis capability and uses thereof.

### BACKGROUND

Material studies that involve characterizing the properties (e.g., structure, topography and chemical composition) of probes in the micro- and nanoscopic regime, can be performed through the implementation of Charged Particle Beam (CPB) microscope systems. Electron microscope systems can perform imaging and analysis can perform imaging and other analyses that are made possible by directing a beam of electrons onto a sample. Similar types of imaging and analyses may be conducted using Focused Ion Beam (FIB) systems, in which the incident charge-particle beam consists of ions instead of electrons. However, FIB systems produce images that are lower in magnification and resolution than what is attainable using SEM systems.

For example, a Scanning Electron Microscope (SEM) may be configured to scan the surface of the sample with a primary charged-particle beam (e.g., an electron beam) and acquire an image of the sample based on various types of emissions e.g., emissions of backscattered, transmitted or secondary electrons. These emissions result from the interaction of the electron beam with the particles of the sample (such as atoms). Backscattered electrons (BSE) originate from the primary electron beam, which, as the name suggests, are reflected back (e.g., out of the sample) via elastic scattering on the sample atoms. The number of backscattered electrons at each scan location on the sample depends on the atomic number of the chemical elements (e.g., mineral elements) located in the corresponding scan location. Thus, the brightness variations (e.g., gray-level variations and contrast) within a BSE image are indicative of the composition variations within the sample.

Alternatively, a Transmission Electron Microscope (TEM) or a Scanning Transmision Microscope (STEM) is configured to record electrons that are transmitted through a sample. In this case, brightness and contrast variations pertain to variations, across a sample, in the number of electrons that are transmitted through the sample. Since electrons have a limited penetration depth, each sample must be a thin fragments or a lamella of essentially uniform thickness. Whereas the detector elements of SEM and FIB apparatuses are disposed at the same side of the sample (e.g., the "top", "upper" or "front" side) from which charged particles are emitted, the detector elements of a TEM or STEM are disposed at the opposite side (e.g., the "bottom", "lower" or "back" side) of the sample. Transmitted charged particles may be focused onto a detector by image transfer elements, such as at least an objective lens assembly and a projection lens assembly, also disposed at the side of the sample that is opposite to the side from which charged particles are received.

Energy Dispersive X-ray (EDX) analysis, also known as Energy-dispersive X-ray spectroscopy (EDS, EDX, EDXS or XEDS), is a powerful analytical technique used to determine the elemental composition of materials. This technique is often associated with electron microscopy, specifically scanning electron microscopes (SEM) and scanning transmission electron microscopes (STEM), due to their ability to generate characteristic X-rays that reveal the presence of elements in the specimens.

An EDX analysis process involves exposing a sample with a focused electron beam, which results in the emission of characteristic X-rays from the atoms within the sample. Each element in the sample emits X-rays at specific energy levels, which are unique to that element. By detecting and analyzing these emitted X-rays, energy-dispersive X-ray spectroscopy can determine the presence and relative abundance of elements within the sample. The emitted X-rays are then detected and analyzed by an energy-dispersive spectrometer. Such a spectrometer is capable of measuring the energy and intensity of the emitted X-rays, which may be used to determine the elemental composition of the sample. Because each element emits X-rays at a unique set of energy levels, it is thus possible to identify elements that are present in a sample as well as their spatial variation within the sample. Within a charged particle beam microscope, this element-mapping technique involves scanning the electron beam across the sample and recording the X-ray emission at each point, thereby resulting in a map that shows, at high magnification, the distribution of each element within the sample.

Charged particle beam microscopes having EDX analysis capability are extensively used in quality control and failure analysis across various industries, including various industries. Its ability to provide accurate and rapid elemental analysis ensures the integrity, consistency, and compliance of materials and products. As the use of such apparatuses expands, so does the pool of potential infrequent users for whom electron microscopy and/or microanalysis are unfamiliar. Regardless, the quality of analytical data that is obtained by EDX microanalysis depends on the ability of users to set instrument operational parameters to their optimal values. One important operational parameter is the time (e.g., dwell time) that is allocated to each spectral acquisition or, essentially equivalently, the signal strength (e.g., digital counts) that is required for accurate statistical analysis of X-ray spectra. If the allocated time is too long, then valuable apparatus time will be wasted and, potentially, a sample may be damaged. If the allocated time is too short, then some or all of the data may be unusable. In either situation, the experiment may need to be repeated with a different time setting, which may or may not provide statistically valid results. Accordingly, there is a need in the art for improved levels of automation of this and other operational parameters.

### BRIEF SUMMARY

The present disclosure provides methods for implementing and using intelligent EDX acquisition stop criteria to enhance the accuracy of peak fitting for specific peaks of interest. The herein disclosed methods utilize the criterion that, ideally, EDX spectral peaks should conform to a Gaussian peak shape, and, therefore, the degree of deviation of a measured spectral peak from pure Gaussian form (i.e., the error in fitting the peak data to Gaussian form) may be taken as a measure of the quality and precision of the data. By utilizing the fitting error, the requirement to predict or to a priori know the acquisition time or the number of counts necessary for accurate statistical analysis of peak data is eliminated.

The novel methods described herein can be utilized in two ways: (a) as a live data-acquisition stopping criterion wherein the fitting error is continuously calculated during each EDX spectral acquisition or as a function of time and wherein EDX data acquisition automatically terminates when the selected peaks achieve a predetermined minimal-fitting-error threshold; and (b) as a data acquisition time predictor wherein the number of EDX spectral acquisitions or time required for precise elemental quantification is based on the current acquisition conditions, sample type or short-term test spectra. The latter predictive capability aids in optimizing the acquisition process by providing an estimation of the resources (e.g., time) that are required for accurate results.

According to a first aspect of the present disclosure, a method for populating a database or database record for choosing or predicting, for a program of EDX analyses, an electron exposure time or a total signal strength for a sample of a first sample type comprises:
(a) setting an initial value of the dwell time or the spectral signal threshold;
(b) directing a charged particle beam onto a specimen of a first known sample type for a time duration equal to the initial dwell time or until the initial spectral signal threshold is met while acquiring an energy-dispersive X-ray emission spectrum of the specimen;
(c) repeatedly:
   changing the value of the dwell time or spectral signal threshold;
   while measuring an X-ray emission spectrum from the specimen or different specimen, directing the charged particle beam onto the specimen or a different specimen of the first known sample type for a time duration equal to the most-recent value of the dwell time or until an observed spectral signal strength is greater than or equal to the most-recent value of the spectral signal threshold; and
   recording the value of the most recent dwell time or spectral signal threshold and recording a value of a metric pertaining to a deviation from Gaussian form of one or more peaks of the most recently acquired X-ray emission spectrum; and
(d) constructing and storing a mathematical relationship, pertaining to the first known sample type, between the plurality of values of the dwell time or spectral signal threshold and the plurality of recorded values of the metric; and
(e) storing the mathematical relationship in the database or database record.

According to a second aspect of the present disclosure, a method for conducting a program of EDX analyses of a sample using a charged particle beam (CPB) microscope comprises:
receiving sample type information from a user;
choosing a total CPB exposure time or total signal strength based on a mathematical relationship, pertaining to the sample type, that is stored in a database constructed according to a method in accordance with the above-described first aspect.

According to a third aspect of the present disclosure, there is provided a system comprising:
a charged particle beam (CPB) microscope comprising an X-ray detector;
a sample stage having a sample of a first sample type thereon; and
a data-processing system electrically coupled to the CPB microscope and the X-ray detector comprising:
   a spectrum processing component;
   a processing unit; and
   a non-transitory, tangible computer readable storage medium electrically coupled to the processing unit and comprising computer readable instructions that, when executed by the processing unit, cause the data processing system, the spectrum processing component, the CPB microscope and the X-ray detector to execute the method of the above-described first aspect.

### BRIEF DESCRIPTION OF THE DRAWINGS

FIG. 1 is a schematic depiction of various components of a Scanning Electron Microscope (SEM) system illustrating conventional components, in solid lines, as well as to additional components and connections, in dashed lines, that are relevant to the present teachings;
FIG. 2 is a graph of an empirically observed trend of deviation from Gaussian peak shape(s) versus integrated peak area(s) such as may be employed in automatically calculating and predicting optimal electron beam exposure time(s) during EDX microanalyses in accordance with the present teachings;
FIG. 3 is a flow diagram of a method, in accordance with the present teachings, for automatically or partially automatically determining optimal electron beam exposure time(s) during EDX microanalysis;
FIG. 4 is a flow diagram of a first method, in accordance with the present teachings, for generating a database comprising information that is usable for calculating or predicting optimal electron beam exposure time(s) during EDX microanalyses;
FIG. 5 is a flow diagram of a second method, in accordance with the present teachings, for generating a database comprising information that is usable for calculating or predicting optimal electron beam exposure time(s) during EDX microanalyses; and
FIG. 6 is a flow diagram of a method, in accordance with the present teachings, for generating and immediately utilizing information for a database comprising information that is usable for calculating or predicting optimal electron beam exposure time(s) during EDX microanalyses.

### DETAILED DESCRIPTION

As used in this application and in the claims, the singular forms "a", "an", and "the" include the plural forms unless the context clearly dictates otherwise. Additionally, the term "includes" means "comprises". Further, the term "coupled" does not exclude the presence of intermediate elements between the coupled items.

The systems, apparatuses, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatuses are not limited to any specific aspect or feature or combinations thereof, nor do the disclosed systems, methods, and apparatuses require that any one or more specific advantages be present or problems be solved. Any theories of operation are to facilitate explanation, but the disclosed systems, methods, and apparatuses are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatuses can be used in conjunction with other systems, methods, and apparatuses. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one or ordinary skill in the art.

In some examples, values, procedures, or apparatuses are referred to as "lowest", "best", "minimum", "greater", "less than", "equal to" or the like. It will be appreciated that such descriptions are intended to indicate that a selection among many used functional alternatives can be made, and such selections need not be better, smaller, or otherwise preferable to other selections.

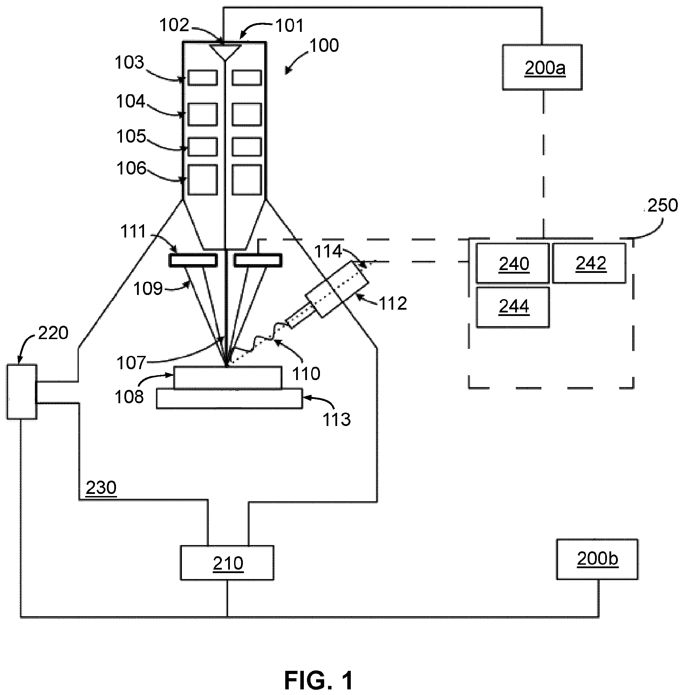

FIG. 1 shows, in schematic fashion, various components of a Scanning Electron Microscope (SEM) system **100.** Although an SEM system is specifically depicted in FIG. 1, the general principles described herein may also be applied to a Scanning Transmission Electron Microscope (STEM) system as well as to a Focused Ion Beam (FIB) sytem. The components that are outlined by or connected by solid lines are conventional components, as is currently known in the art. The optional components that are outlined by or connected by dashed lines are relevant to the present disclosure. The scanning microscope system **100** may be configured for generating a primary beam of charged particles (e.g., electrons or ions). The scanning microscope system may further comprise a scanning electron microscope **101.** In this example, the primary beam comprises an electron beam **107.** An electron source **102** may be configured for emitting the electron beam, wherein a voltage is applied between the electron source **102** and an anode **103.** The applied voltage may preferably range from at least 2 kV to at most 30 kV. The scanning microscope system may also comprise electromagnetic lenses that may be configured for controlling the path of the electron beam. The electromagnetic lenses may comprise at least one condensing lens **104.** The condensing lens **104** may be configured for determining the size of the electron beam. Moreover, the electromagnetic lenses may comprise at least one objective lens **106.** The objective lens **106** may be configured for focusing the electron beam to a scan point on the sample. The scan point may correspond to an electron-beam spot on a sample **108.** The dimensions and the shape of the scan point may depend on the focusing properties of the electromagnetic lenses (e.g. applied current) and the working distance between the scanning electron microscope **101** and the sample **108.** A scanning coil **105,** which may be either magnetic or electrostatic, may be configured for deflecting the electron beam **107** over a plurality of scan locations in one or two dimensions. This scanning capability may enable two-dimensional scanning of the sample **108.** Each scan point may correspond to a respective pixel of an image of the sample generated by the electron microscope **101.**

The scanning microscope system **100** can be configured for detecting at least first emissions **109** and second emissions **110** from each scan point of the sample **108** upon interaction of the electron beam **107** with the respective scan point. The first emissions **109** may comprise emissions of charged particles, such as backscattered electrons. However, the first emissions may also comprise emissions of secondary, transmitted and/or Auger electrons. Further, the second emissions **110** comprise emissions of X-rays.

The scanning microscope system **100** may comprise a first detector **111,** wherein the first detector **111** is configured for detecting the first emissions **109** from a first series of scan points that are exposed to the electron beam **107** in a sequential manner. In particular, the first detector **111** may be configured for detecting the first emissions over a first dwell time at each scan point of the first series of scan points. In some examples, the first detector **111** may comprise a backscattered electron detector, such as a segmented silicon drift detector. However, the backscattered electron detector may also comprise other types of solid-state detectors. Moreover, the first detector **111** may also comprise a secondary electron detector, such as an Everhart-Thornley detector.

Further, in accordance with the present disclosure, the charged particle beam microscope system comprises a second detector **112,** wherein the second detector **112** is configured for detecting X-ray emissions **110** from either the first series of scan points or from a second series of scan points in a sequential manner. According to the present disclosure, the second detector **112** comprises an energy-dispersive spectrometer (EDX) and may be configured for detecting emitted X-rays over a second dwell time at each first scan point. The angle between a center line **114** of the second detector and the sample surface may be adjustable and may range from 0° to at most 90°. The energy bandwidth of the EDX may range from 0 to at most 17 keV.

If the system **100** is an STEM system (instead of the illustrated SEM system), the depicted first detectors **110** may be omitted and replaced by a transmitted electron detector (e.g., a CMOS detector, not shown) that is disposed below the sample **108** in order to detect electrons that are transmitted through the sample. In such instances, the system **100** may also comprise substage objective lens and projection lens components (not shown) between the sample and the transmitted electron detector.

The scanning microscope system **100** may further comprise a control unit **200a.** The control unit **200a** may be configured for controlling the power supply and operation of the condensing lens **104,** the objective lens **106,** the scanning coil **105** and the movable sage **113.** Further, the scanning microscope system may comprise a vacuum system. The vacuum system may comprise a vacuum controller **200b,** a mechanical pumping system **210,** an ultra-high vacuum pump **220** (such as an ion pump) and a vacuum chamber **230.** The vacuum controller **200b** may be configured for controlling the operation of the mechanical pumping system **210** and the ultra-high vacuum pump **220.** The mechanical pumping system **210** and the ultra-high vacuum pump **220** may be configured for providing an ultra-high vacuum within the vacuum chamber **230.** The vacuum chamber may be configured for containing the sample **108,** the movable stage **113,** the first detector **111,** the second detector **112** or parts thereof, and the scanning electron microscope **101** or parts thereof.

The sample **108** may be positioned on top of a movable stage **113.** The movable stage **113** may be configured for performing two horizontal movements, a vertical movement, a tilting movement, and/or a rotational movement, either within or with respect to the plane of the sample. The two horizontal movements may comprise selecting a field of view. The vertical movement may change a height of the sample and thus the depth of focus and/or the image resolution.

The system shown in FIG. 1 further comprises a data-processing system **250.** The data-processing system **250** may comprise one or more processing units configured to carry out computer instructions of a program (e.g. machine readable and executable instructions). The processing unit(s) may be singular or plural. For example, the data-processing system **250** may comprise at least one of CPU, GPU, DSP, APU, ASIC, ASIP or FPGA.

In one example, a spectrum processing component **244** of the data processing system **250** may be configured for forming X-ray spectra based on X-rays detected by the Energy Dispersive X-ray detector **112.** The spectrum processing component **244** may be configured for counting and sorting the detected X-rays (at each respective scan point) based on the energies of the respective X-rays for the duration of the second dwell time. The spectrum processing component **244** may also be configured for fitting one or more Gaussian peaks to X-ray spectra and determining deviations between observed X-ray spectra and the Gaussian-form fit peaks.

In another example, an image processing component **246** of the data processing system **250** may be configured for constructing images of the sample based on data received from the first detector **111.** The data may comprise, for each first scan point, a number of digital counts detected by a detector over the course of a time period having a predetermined duration (i.e., first or second dwell time), wherein the number of counts received during the predetermined dwell time is translated, by the processing unit **246** into a respective intensity of a respective image pixel. In some instances, the number of counts that are used to display an image may pertain to the detection, by the second detector **112,** of X-rays having a certain energy (in EDX mode) or having a certain wavelength (in WDS mode). The derived image may then depict the locations, within a sample, of areas within which certain elements are concentrated. In some other instances, the number of counts may pertain to detection, by the first detector **111,** of a quantity of electrons emitted from or scattered from the scan point. In some other instances, the number of counts may pertain to detection, by a substage detector (not shown), of a quantity of electrons transmitted through the sample. The processing component **246** may store the number of detected counts received from each scan point in a respective location of a digital array. The processing component **246** may further store scaling information that may be used to translate the digital array locations into physical coordinates of each respective scan point on the sample.

Further, the data-processing system **250** may comprise a parameter settings component **242.** The parameter settings component may accept, from user input, the values of apparatus parameters that are to be employed for subsequent electron microscopic imaging and/or analysis of a sample. Such parameters may include, but are not limited to: electron or ion beam energy, electron or ion beam current, lens current and/or lens voltage, detector(s) to be used, detector gain, dwell times, sample damage threshold, acceptable image noise threshold, minimum acceptable signal per point, etc.

The data-processing system **250** may further comprise memory components, such as a data-storage component **240.** The data-storage component **240** as well as the data-processing system **250** may comprise at least one of main memory (e.g. RAM), cache memory (e.g. SRAM) and/or secondary memory (e.g. HDD, SDD). The data-processing system **250** may comprise volatile and/or non-volatile memory such an SDRAM, DRAM, SRAM, Flash Memory, MRAM, F-RAM, or P-RAM. The data-processing system **250** may comprise internal communication interfaces (e.g. busses) configured to facilitate electronic data exchange between components of the data-processing system **250,** such as, the communication between the memory components and the processing components. The data-processing system **250** may include external communication interfaces configured to facilitate electronic data exchange between the data-processing system and devices or networks external to the data-processing system. In the example of FIG. 1, the external communication interfaces may be configured for facilitating an electronic connection between the processing components of the data-processing system **250** and components of the scanning microscope system **100,** such as the control unit **200a.**

Furthermore, the external communication interfaces may also be configured for establishing an electronic data exchange between the data-processing system **250** and the first detector **111.** The external communication interfaces may also be configured for facilitating an electronic connection between the data-processing system **250** and the second detector **112.** For example, the detected backscattered electron data from every scan point may be stored in the data-storage component **240.** Likewise, a backscattered charged-particle-beam image of the sample and Energy Dispersive X-ray spectra from each scan point may be stored in the data-storage component **240.**

The data-processing system may also comprise network interface card(s) that may be configured to connect the data-processing system to a network, such as, to the Internet. The data-processing system may be configured to transfer electronic data using a standardized communication protocol. The data-processing system may be a centralized or distributed computing system. The data-processing system may comprise user interfaces, such as an output user interface and/or an input user interface. For example, the output user interface may comprise screens and/or monitors configured to display visual data (e.g. a backscattered charged-particle beam image of the sample or an X-ray spectrum). The input user interface may e.g. a keyboard configured to allow the insertion of text and/or other keyboard commands (e.g. allowing the user to enter parameters for use during subsequent data acquisition) and/or a trackpad, mouse, touchscreen and/or joystick (e.g., configured for navigating a charged particle beam image, selecting regions of interest within such an image or displaying X-ray spectra obtained from various sample locations that are depicted on the image.

In some examples, the data-processing system **250** may be a processing unit configured to carry out instructions of a program. The data-processing system **250** may be a system-on-chip comprising processing units, memory components and busses. The data-processing system **250** may be a personal computer, a laptop, a pocket computer, a smartphone, a tablet computer. The data-processing system may comprise a server, a server system, a portion of a cloud computing system or a system emulating a server, such as a server system with an appropriate software for running a virtual machine. The data-processing system may be a processing unit or a system-on-chip that may be interfaced with a personal computer, a laptop, a pocket computer, a smartphone, a tablet computer and/or user interfaces (such as the upper-mentioned user interfaces).

At least one of the spectrum processing component **244,** the image processing component **246** and the parameter settings component **242** of the data-processing system **250** may be implemented in software. One, some, or all of these components may be a software component, or at least comprise one or more software components. The data-processing system **250** may be configured for running said software components, and/or for running a software comprising the software components. In other words, the components may comprise one or more computer instructions (e.g. machine-readable instructions) which may be executed by a computer (e.g. the data-processing system **250**)**.** At least one of the spectrum processing component **244,** the image processing component **246** and the parameter settings component **242** may be stored on one or more different storage devices. For example, the at least one of the components may be stored on a plurality of storage components comprising persistent memory, for example a plurality of storage devices in a RAID-system, or different types of memory, such as persistent memory (e.g. HDD, SDD, flash memory) and main memory (e.g. RAM). The components may also be implemented at least partially in hardware. For example, at least one of the spectrum processing component **244,** the image processing component **246** and the parameter settings component **242** or at least a part of one of their functionalities may be implemented as a programmed and/or customized processing unit, hardware accelerator, or a system-on-chip that may be interfaced with the data-processing system **250,** a personal computer, a laptop, a pocket computer, a smartphone, a tablet computer and/or a server.

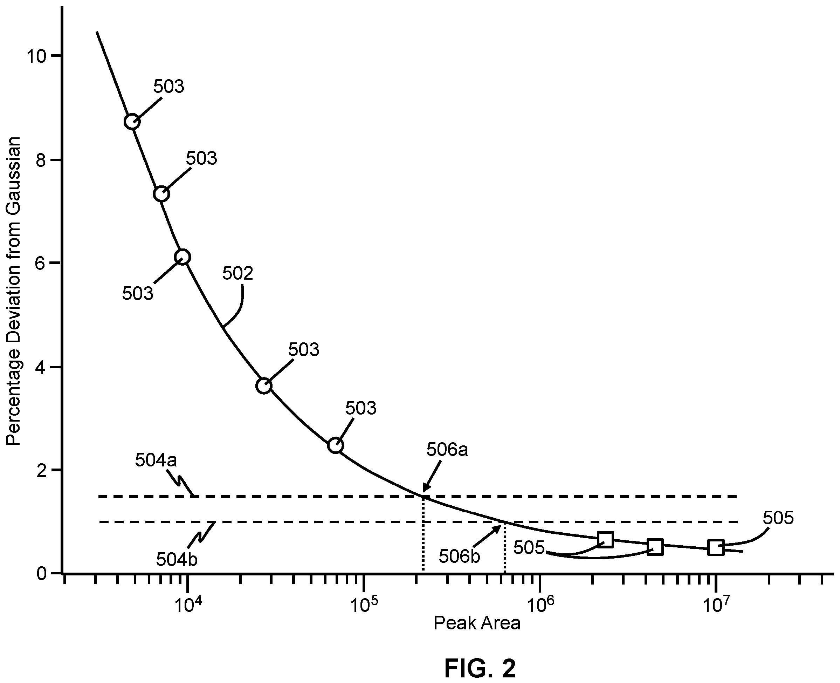

FIG. 2 is a graph of an empirically observed trend of deviation from Gaussian peak shape(s) versus integrated peak area(s) such as may be employed in automatically calculating and predicting optimal electron beam exposure time(s) during EDX microanalyses in accordance with the present teachings. In this graph, the abscissa represents, according to a logarithmic scale, the integrated area "under the curve" of an EDS spectral peak or, possibly, a plurality of plurality of EDX spectral peaks of interest taken as a group, where each peak encompasses a plurality of bins or channels, each channel representing detection of X-rays having a respective photon energy and comprising a respective value (e.g., digital counts) that corresponds to a quantity of photons detected at that respective energy. Note that the channels/energies are not themselves represented in the graph of FIG. 2; only the total counts across a plurality of such channels are represented by the abscissa.

The ordinate of FIG. 2 represents the deviation, relative to pure Gaussian peak form, of a Gaussian fit to the peak or peaks of interest. The Gaussian fit (or fits) may be calculated, for example, by the spectrum processing component **244** of the data-processing system **250** (FIG. 1). The deviation, which may also be determined by the spectrum processing component **244,** may be determined by any one of several methods, such as a goodness-of-fit statistical analysis method. However, since there may exist experimental requirements to calculate the deviation repeatedly in "real time", at the same time that spectral data is being collected, the inventors have found that, for means of efficiency, the deviation-from-Gaussian character may be defined as a percentage of residual counts that are located at three or more standard deviations from the fitted Gaussian mean, in either direction.

As may be observed from the graph **502** of FIG. 2, the deviation from Gaussian peak shape decreases with increasing signal strength (i.e., peak area) or, alternatively, increasing data acquisition time. With increasing signal strength, the deviation-from-Gaussian metric will decrease to below a threshold value (e.g., threshold value **504a** or alternative threshold value **504b**) at which, according to various sample characteristics and/or experimental requirements, the fitting quality is sufficient, such as is the case for hypothetical data points **505,** to render the corresponding calculated peak area useable for analytical purposes. Observations of hypothetical data points **503** that are above a chosen threshold value indicate that additional data collection time (dwell time or frame time) is required to obtain usable results. FIG. 2 also illustrates the importance of choosing a correct threshold value for the sample being analyzed and the specific requirements of a particular analysis workflow. For example, if the threshold value is incorrectly set at **504b** when the threshold value **504a** would otherwise be sufficient, then the required analysis time is unnecessarily multiplied by a factor of approximately three.

Data such as that used for construction of the graph **502** of FIG. 2 may be stored as a file or as a record within a database within the data-storage component **240.** The data that is stored in the file or database record may later be used to intelligently choose or predict, for a program of EDX analyses, an electron exposure time (e.g., a dwell time or a frame exposure time) or a total signal strength (e.g., integrated counts) that is optimal for a particular sample or sample type and for particular experimental requirements (e.g., particular elements that are being detected by EDX, required precision of measurements, etc.). For this purpose, the data within the file or database may be organized by sample type and/or experimental requirements.

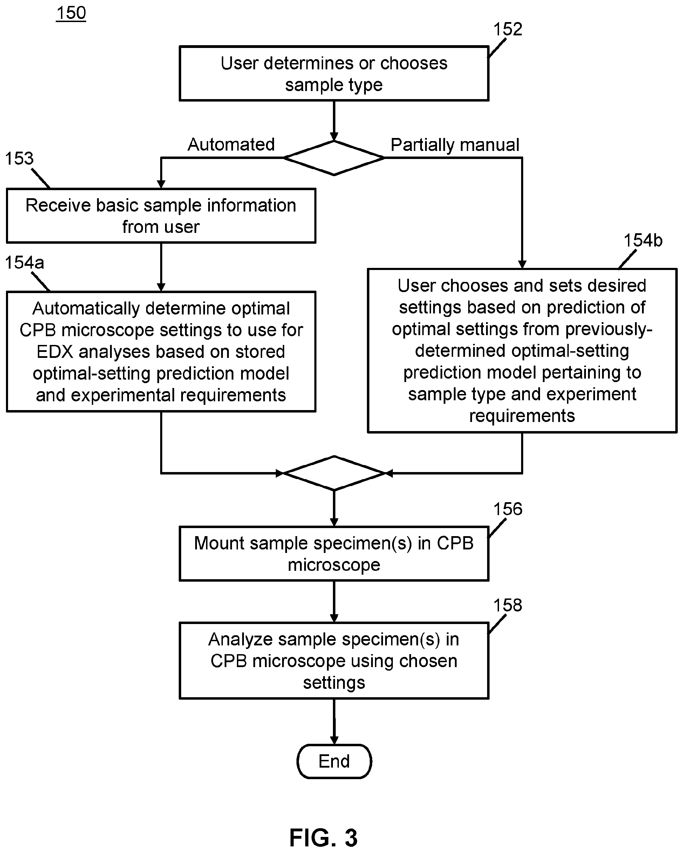

FIG. 3 is a flow diagram of a method **150,** in accordance with the present disclosure, for using the stored data for such purposes. In a first step, Step **152** of the method **150,** a user determines or chooses one or more specimens of one or more sample types for analyses. For example, the sample type may be defined by the composition of the sample, such as metal, semiconductor, glass, plastic, organic, etc.

According to an automated example of the execution of method **150,** the step **153** is executed, in which the user inputs only basic information (e.g., the sample type, preferred analytical precision, maximum time for analysis, etc.) to a data processing system (e.g., data-processing system **250)** that is in communication with a charged particle microscope system. The parameter settings component **242** of the data processing system then uses this input information, in Step **154a,** to automatically determine an optimal set of instrument operational parameters, including the optimal time duration required to expose the sample, or portions of the sample, to a charged particle beam during EDX analyses.

According to an alternative, partially-manual execution of the method **150,** the step **154b** is executed instead of the pair of steps **153, 154a.** In the step **154b,** the user directly consults the stored results and chooses appropriate values of exposure time, dwell time, frame time, etc. that are then manually input to the data-processing system **250** and then implemented by the parameter settings component **242.** Steps **156** and **158** are executed in any case. In step **156,** the sample specimen(s) is/are mounted and in step **158** the sample specimen(s) is/are analyzed using the automatically or manually chosen operational parameters.

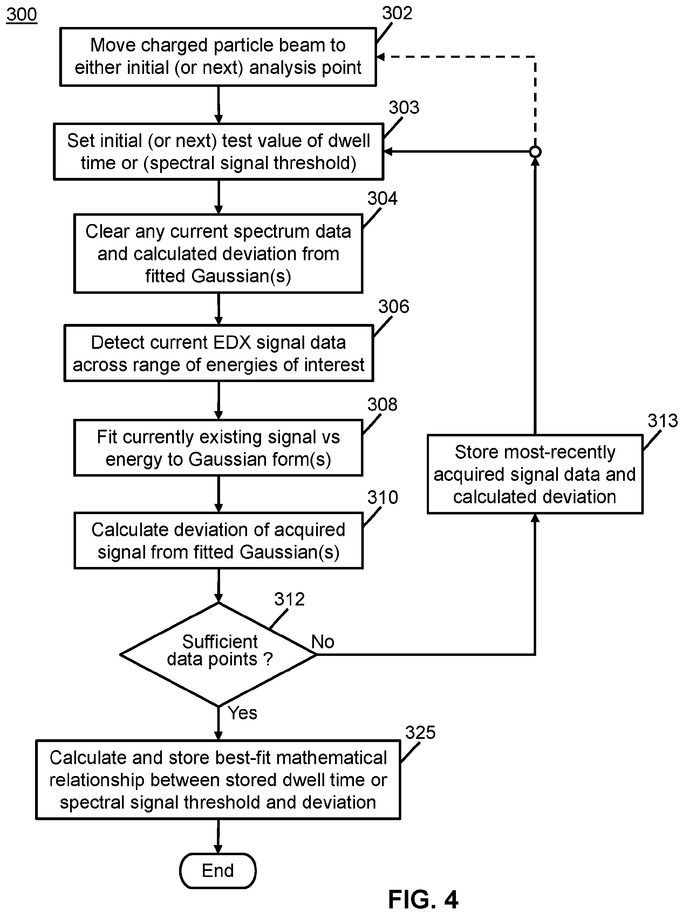

FIG. 4 is a flow diagram of a first method **300** for generating and storing information that may then be utilized by a user to intelligently choose or predict, for a program of EDX analyses, an electron exposure time or integrated signal strength that is optimal for a particular sample or sample type and for particular experimental requirements. For example, the method **300** may be employed to generate data such as is graphed in FIG. 2. The method **300** comprises a loop of steps (e.g., Step **303** through Step **312** or, optionally, Step **302** through Step **312**) that are iterated, each iteration generating a single data point.

In an initial step, Step **304** of the method **300,** a charged-particle beam is moved to either an initial (or next) analysis point on a sample. Alternatively, step **302** may be skipped for all but the first iteration of the loop of steps, such that the analysis point may remain the same for some or all iterations of the loop. In Step **303,** an initial (or next) test value of either a dwell time or a spectral signal threshold (e.g., threshold **504a** or **504b)** is chosen and implemented in apparatus settings. In Step **304,** any currently existing spectrum data and/or previously-calculated fitting deviations may be cleared from computer memory. Once Step **304** has been executed, then, in Step **306,** the setting that was set in the most recent execution of Step **303** is used during acquisition of a new EDX spectrum that spans a range of X-ray energy levels of interest.

In Step **308,** the spectrum that was acquired in Step **306** is modeled by fitting one or Gaussian peaks to the spectral data and, subsequently, in Step **310,** a deviation of the actual data from the model Gaussian peaks is calculated. The deviation may be calculated by any one of several methods, such as a goodness-of-fit statistical analysis method. However, the inventors have determined that, for efficient calculation, the deviation-from-Gaussian character may be defined as a percentage of residual counts that are located at three or more standard deviations, in each direction, from each fitted Gaussian mean value. The utilized test value (as set in Step **303**) and the determined deviation-from-Gaussian mean value, as determined in Step **310,** are then used to construct a single data point, such as one of the data points **503, 505** that are schematically depicted in FIG. 2.

Step **312** of the method **300** is a decision step in which it is determined if a sufficient number of data points have been obtained. For example, this determination may be based on the quality of fit of the data points **503, 505** to a particular model curve **502.** The determination may also be based whether the fit to the model curve either crosses a desired EDX spectral threshold value **504a, 504b** or otherwise may be reliably extrapolated to predict the dwell time or integrated signal level at such a threshold value. If, at the decision step **312,** there are an insufficient number of data points, then the "No" branch of Step **312** is executed whereby the most-recently-acquired signal data and calculated deviation is stored as a new data point and execution returns to Step **303** or, optionally, Step **302,** at which a new iteration of the loop of steps is initiated so at to generate another data point. Otherwise, the "Yes" branch of Step **312** is executed whereby, at Step **325,** a best-fit mathematical relationship, such as the relationship shown by curve **502** of FIG. 2, is constructed between the determined deviations and the stored dwell times or spectral signal magnitudes. The constructed mathematical relationship may only pertain to and be useful for a particular sample type. It may therefore be necessary to perform a separate execution of the method **300** for each type of sample upon which EDX analyses are to be performed.

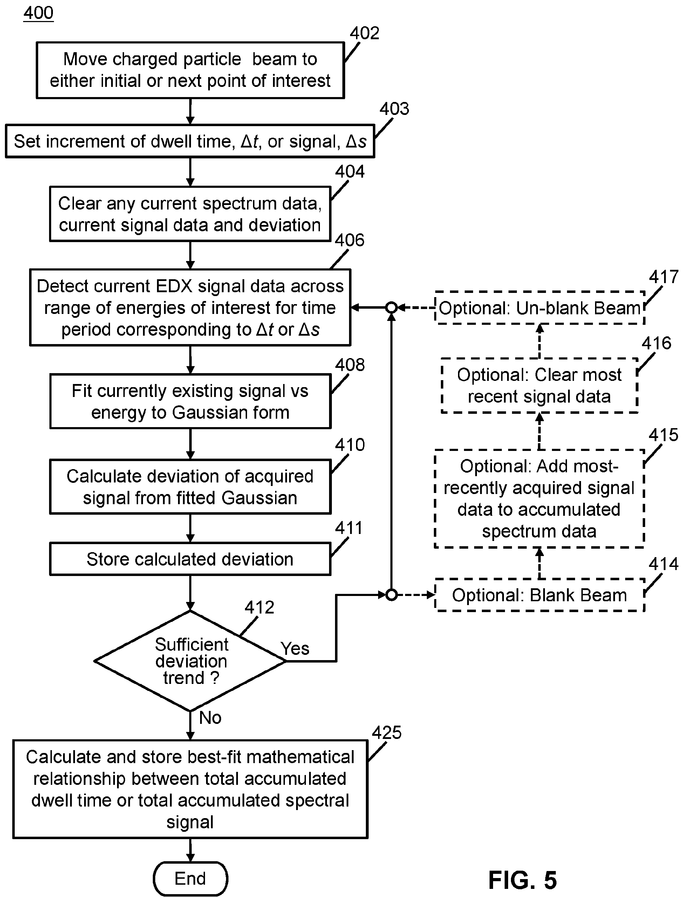

FIG. 5 is a flow diagram of a second method **400** for generating and storing information that may then be utilized by a user to intelligently choose or predict, for a program of EDX analyses, an electron exposure time or integrated signal strength that is optimal for a particular sample or sample type and for particular experimental requirements. The method **400** (FIG. 5) is a modified version of the method **300** of FIG. 4 wherein a single sample is continuously or nearly continuously exposed to a charged particle beam during which time periodic EDX spectral "samples" are acquired. Accordingly, the steps **402, 404, 406, 408, 410** and **425** of the method **400** are identical to the steps **302, 304, 306, 308, 310** and **325,** respectively, of the method **300** and are therefore not discussed in detail. Steps **403** and **406** are similar to the steps **303** and **306,** respectively, except that, whereas the steps **303** and **306** pertain to setting specific test values of total exposure time or targeted threshold signal level that vary, from one exposure to the next, over the course of several respective exposures, the steps **403** and **406** pertain, instead, to either an increment of time, Δ*t*, or of signal level, Δ*s*, at which samples of accumulated spectral signal are obtained over the course of a single exposure.

Correspondingly, the decision step **412** of method **400** differs from the decision step **312** of method **300** in that, whereas the step **312** requires an assessment of a total number of data points, the decision step **412** instead requires an assessment of whether or not a trend of the deviation from Gaussian peak shape has been sufficiently established to either identify that either (a) the deviation has diminished to below a desired threshold value or (b) the trend may be reliably extrapolated to determine a time or signal level at which the trend will cross the threshold.

If, at the decision step **412,** the trend of the deviation is not sufficiently established as described above, then the "Yes" branch of Step **412** is executed, from which execution of the method may loop back to Step **406** at which the exposure of the sample to the charged particle beam is continued for at least another increment of time, Δ*t*, or of signal level, Δ*s*. This flow of control assumes that the execution of the calculation steps **408, 410** are sufficiently fast to keep pace with the continued spectral acquisitions (step **406**)**.** If this assumption is not true, then the charged particle beam may need to be blanked (optional Step **414)** and later unblanked (optional Step **417**) to pause beam exposure while the calculation steps execute. In such instances, the most recently acquired signal data (e.g., acquired during an increment, Δ*t*, or of signal level, Δ*s*, since an immediately preceding un-blanking step) may be temporarily stored and then added to the accumulated spectral data (optional Step **415)** before being discarded (optional Step **416).**

Once the deviation from Gaussian form has been sufficiently established through collection of enough data points, then the execution of the method proceeds to step **425** at which a best-fit mathematical relationship, such as the relationship shown by curve **502** of FIG. 2, is constructed. The constructed mathematical relationship may then be either interpolated or extrapolated to either identify or predict an exposure time or total signal level above which data of sufficient quality may be obtained. The so-determined mathematical relationship may only pertain to and be useful for a particular sample type. It may therefore be necessary to perform a separate execution of the method **400** for each type of sample upon which EDX analyses are to be performed.

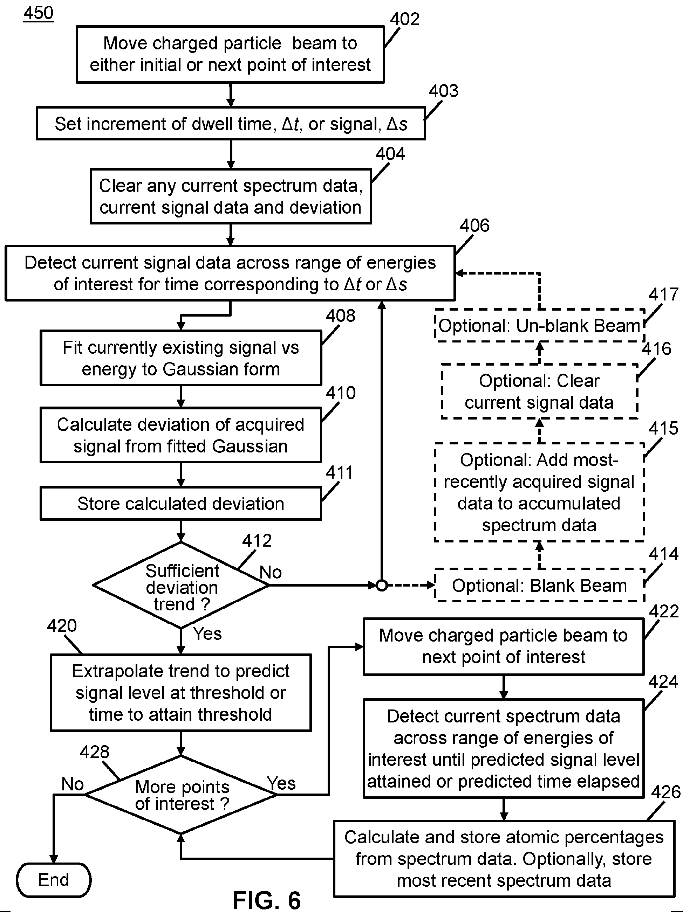

FIG. 6. is a flow diagram of a method **450** for generating and immediately utilizing information for a database comprising information that is usable for calculating or predicting optimal electron beam exposure time(s) during EDX microanalyses. Unlike the previously-described methods **300** and **400** in which a mathematical relationship is constructed between Gaussian peak shape and either dwell time or signal level, no such mathematical relationship is calculated by the method **450.** Instead, only a single threshold of exposure time or signal level is identified for a particular sample and this threshold, once identified is used for subsequent analyses of the same sample. Accordingly, the method **450** may be suitable for analysis of a sample of a type that is either rare or otherwise not generally analyzed.

Since the method **450** (FIG. 6) is a modified version of the method **400** (FIG. 5), the steps **402, 403, 404, 406, 408, 410, 411, 414, 415, 416** and **417** of the method **450** are identical to their similarly numbered counterpart steps of the method **400** and are, therefore, not discussed further. The decision step **412** of the method **450** is similar to the similarly numbered counterpart step of the method **400** except that, whereas the decision that is made in Step **412** pertains to a sufficiency of data that is suitable for construction a mathematical relationship, the decision that is made in Step **412** of the method **450** pertains only to a sufficiency of data that is suitable for reliable extrapolation to a threshold value. When the execution of the method **450** follows the "Yes" branch of the decision step **412,** then the step **420** is executed, wherein the observed trend of deviation from Gaussian form is extrapolated in order to predict a threshold value of dwell time or signal level.

After identification of the threshold value, execution of the method **450** proceeds to a decision step **428** at which a determination is made regarding whether additional points of interest on the sample are to be analyzed. If so, execution passes to Step **422,** at which charged particle beam is directed to a next point of interest on the sample and then to Step **424** at which an EDX spectrum of the sample at the point of interest is obtained across a range of X-ray energies of interest until, according the extrapolation of Step **420,** either the predicted threshold signal level has been attained or the predicted threshold dwell time has elapsed. From the acquired EDX data, atomic percentages of elements of interest are calculated in Step **426.** Preferably, the Step **426** also includes storing the EDX spectral data for later study. Execution may then return to Steps **428** from which additional points of interest on the sample may be analyzed by further iteration of the steps **422, 424** and **426.**

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While specific illustrated example embodiments described herein specifically depict Scanning Electron Microscope (SEM) systems, these are meant as non-limiting, illustrative embodiments. Embodiments of the present disclosure are not limited to such systems, but rather are intended to include Focused Ion Beam (FIB) systems as well as Transmission Electron Microscope (TEM) systems and Scanning Transmission Electron Microscope (STEM) systems.

Some embodiments of the present disclosure include a system including one or more data processors and/or logic circuits. In some embodiments, the system includes a non-transitory computer readable storage medium containing instructions which, when executed on the one or more data processors, cause the one or more data processors to perform part or all of one or more methods and/or part or all of one or more processes and workflows disclosed herein. Some embodiments of the present disclosure include a computer-program product tangibly embodied in a non-transitory machine-readable storage medium, including instructions configured to cause one or more data processors to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

## Claims

1. A method for populating a database or database record for choosing or predicting, for a program of EDX analyses, an electron exposure time or a total signal strength for a sample of a first sample type, comprising:
(a) setting an initial value of the dwell time or the spectral signal threshold;
(b) directing a charged particle beam onto a specimen of a first known sample type for a time duration equal to the initial dwell time or until the initial spectral signal threshold is met while acquiring an energy-dispersive X-ray emission spectrum of the specimen;
(c) repeatedly:
changing the value of the dwell time or spectral signal threshold;
while measuring an X-ray emission spectrum from the specimen or different specimen, directing the charged particle beam onto the specimen or a different specimen of the first known sample type for a time duration equal to the most-recent value of the dwell time or until an observed spectral signal strength is greater than or equal to the most-recent value of the spectral signal threshold; and
recording the value of the most recent dwell time or spectral signal threshold and recording a value of a metric pertaining to a deviation from Gaussian form of one or more peaks of the most recently acquired X-ray emission spectrum; and
(d) constructing and storing a mathematical relationship, pertaining to the first known sample type, between the plurality of values of the dwell time or spectral signal threshold and the plurality of recorded values of the metric; and
(e) storing the mathematical relationship in the database or database record.

2. A method as recited in claim 1, wherein:
the X-ray emission spectrum is from the different specimen; and
the specimen and the different specimen are different locations on a same sample surface.

3. A method as recited in claim 1, wherein the charged particle beam is an electron beam within an electron microscope.

4. A method as recited in claim 1, wherein the charged particle beam is an ion beam within a Focused Ion Beam apparatus.

5. A method as recited in claim 1, wherein the step (e) of storing the mathematical relationship further comprises storing the mathematical relationship in a database that is organized according to sample type and that comprises other mathematical relationships between the metric and either dwell time or signal level, wherein the other mathematical relationships pertain to other sample types.

6. A method for conducting a program of EDX analyses of a sample using a charged particle beam (CPB) microscope, the method comprising:
receiving sample type information from a user;
choosing a total CPB exposure time or total signal strength based on a mathematical relationship, pertaining to the sample type, that is stored in a database constructed according to the method of claim 1.

7. A method as recited in claim 6, wherein a chosen CPB exposure time comprises a value of a minimum dwell time that is predicted to yield images having an acceptable noise level, upon imaging specimens of the sample type with the CPB microscope.

8. A method as recited in claim 6, wherein a chosen signal strength comprises a value of a minimum signal strength that is predicted to yield images having an acceptable noise level, upon imaging specimens of the first sample type with the CPB microscope.

9. A method as recited in claim 6, further comprising choosing between imaging in frame integration mode and imaging in line integration mode based on information stored in the database.

10. A method as recited in claim 5, wherein the charged particle beam is an electron beam within an electron microscope.

11. A method as recited in claim 5, wherein the charged particle beam is an ion beam within a Focused Ion Beam apparatus.

12. A method as recited in claim 1, wherein each value of the metric is a goodness fit calculation between the most recently acquired X-ray emission spectrum and a mathematical fit to the most recently acquired X-ray emission spectrum that comprises one or more peaks of Gaussian form.

13. A method as recited in claim 1, wherein each value of the metric is calculated as a percentage of residual counts that are located at three or more standard deviations away from a mean of a Gaussian fit to a spectral peak.

14. A system comprising:
a charged particle beam (CPB) microscope comprising an X-ray detector;
a sample stage having a sample of a first sample type thereon; and
a data-processing system electrically coupled to the CPB microscope and the X-ray detector comprising:
a spectrum processing component;
a processing unit; and
a non-transitory, tangible computer readable storage medium electrically coupled to the processing unit and comprising computer readable instructions that, when executed by the processing unit, cause the data processing system, the spectrum processing component, the CPB microscope and the X-ray detector to execute the method of claim 1.
